# EUROPEAN PATENT SPECIFICATION

(11) **EP 1 311 029 B1**
(45) Date of publication and mention of the grant of the patent: **13.09.2006**
(21) Application number: 03000661.3
(22) Date of filing: 10.10.1997
(51) Int. Cl.: H01R 12/32

(54) **High density connector and method of manufacture**
Steckverbinder hoher Kontaktdichte und Herstellungsverfahren
Connecteur à haute densité et procedé de fabrication

(30) Priority: 10.10.1996 US 728194; 31.12.1996 US 777579; 31.12.1996 US 778380; 31.12.1996 US 778398; 31.12.1996 US 777806
(43) Date of publication of application: 14.05.2003
(62) Divisional of application: 97117583.1
(73) Proprietor: FCI, 78000 Versailles (FR)
(72) Inventor: Lemke, Timothy A., Dillsburg, Pennsylvania 17019 (US); Houtz, Timothy W., Etters, Pennsylvania 17319 (US)
(74) Representative: Beetz & Partner

(56) References cited:
- EP-A- 0 534 223
- EP-A- 0 843 383
- WO-A-98/15990
- US-A- 5 358 417
- US-A- 5 515 604

## Description

The present invention relates to a method for placing a fusible electrically conductive material on the exterior side of an electrical high density connector and an electrical high density connector manufactured with this method.

The drive to reduce the size of electronic equipment, particularly personal portable devices, and to add additional functions to such equipment, has resulted in an ongoing drive for miniaturization of all components, especially electrical connectors. Efforts to miniaturize connectors have included reducing the pitch between terminals in single or double row linear connectors, so that a relatively high number of I/O or other lines can be interconnected by connectors that fit within tightly circumscribed areas on the circuit substrates allotted for receiving connectors. The drive for miniaturization has also been accompanied by a shift in preference to surface mount techniques (SMT) for mounting components on circuit boards. The confluence of the increasing use of SMT and the required fine pitch of linear connectors has resulted in approaching the limits of SMT for high volume, low cost operations. Reducing the pitch of the terminals increases the risk of bridging adjacent solder pads or terminals during reflow of the solder paste. To satisfy the need for increased I/O density, array connectors have been proposed. Such connectors have a two dimensional array of terminals mounted on an insulative substrate and can provide improved density. However, these connectors present certain difficulties with respect to attachment to the circuit substrates by SMT techniques because the surface mount tails of most, if not all, of the terminals must be beneath the connector body. As a result, the mounting techniques used must be highly reliable because it is difficult to visually inspect the solder connections or repair them, if faulty. In the mounting of an integrated circuit (IC) on a plastic or ceramic substrate the use of ball grid array (BGA) and other similar packages has become common. In a BGA package, spherical solder balls attached to the IC package are positioned on electrical contact pads of a circuit substrate to which a layer of solder paste has been applied, typically by use of a screen or mask. The unit is then heated to a temperature at which the solder paste and at least a portion or all of the solder ball melt and fuse to an underlying conductive pad formed on the circuit substrate. The IC is thereby connected to the substrate without need of external leads on the IC.

In many recent patents efforts for miniaturization of products using a SMT technology appear.

The patent application WO 98 / 15990 discloses a Ball Grid Array (B G A) technology applied to a low profile board-to-board connector system where only the reduction of the height of the assembly is required. In this purpose, contacts and solders element are designed to be the most compact as possible.

WO 97/20454 discloses a high density connector able to connect an electronic package comprising solder element and a circuit board in which the contact includes a surface mount section having a convex bottom surface with a shape which simulates at least a lower portion of a sphere and which mimics a solder ball.

US-A- 5593322 relates to a high density connector having fuse ball contacts located at the surface of the bottom of a male connector to connect a component to the surface of a PCB according to the well known BGA technology in which plastic supports provided on their four surfaces with metal strips are connected to a pad located at the bottom of the surface of the insulation body. Then the connector is solded to the PCB by means of a solder ball attached to the pads.

It is also known from US-A- 4 767 344 that an electrical connection can carried out by a body of reflowable material. However, as an amount of solder encircles the pin contact and envelops a predetermined region along the length of the pin this process is not applicable to a high density (with a small pitch between the rows and the columns) connector of the surface mounted type.

The patent application WO 96/42123 filed by the same applicant discloses components using contacts with a lower section comprising a bent terminal tab where the fusible material is applied to the bent surface of the tabs.

EP 0591772 A1 teaches another way to sold connectors to a multi layers PCB using contact pads. However this teaching is limited to components without contacts located in an insulation housing.

US-A 5 495 668 teaches the use of links between a semi conductor chip and a printed circuit board. Links are performed by means of wires provided at their ends with solder bumps. Once again, the components are not located in an insulation housing.

US-A 5 131 871 relates to a design able to reduce the stress in a connector block in a high density connector. As the walls specifying an aperture are thin the invention offers to strengthen it by using projections. These projections provide supporting means for a contact but does not secure the contact by deformation.

US-A 5 358 417 teaches a power connector using a insulative body through which a plurality of cables extend. The contact of the end of these cables occurs onto a pad and wires of these cables are mated by a conductive gel able to maintain wires and pad in abutment without solder balls.

EP 0782220-A2 relates to gripping means provided within apertures located in a body. Gripping means are performed by latches acting on conductive cables of ribbon cables.

Other patents were applied for inventions made to limit the wicking effect during the welding process. For example WO 97/45896 teaches a small connector for mobile phone where the length of the contact is short between its two ends. As one of the ends is dedicated to be the surface receiving the solder for surface mount process, only one portion of this contact has a nickel plating to prevent solder wicking.

US-A 3 864 004 discloses a circuit board socket with a portion of the spring contact coated with a solder resist coating in order to assure that any molten solder wicking does not flow up onto spring.

DE PS 3 712 691 teaches also a coated electrical pin comprising an intermediate nickel layer acting as anti-diffusion barrier.

US-A 5 453 017 discloses the use of a layer of non-solderable material as coating such that solder doesn't adhere to longitudinal side.

While the use of BGA and similar systems in connecting an IC to a substrate has many advantages, a corresponding means for mounting an electrical connector or similar component on a printed wiring board (PWB) or other substrate has yet to be developed. It is important for most situations that the substrate-engaging surfaces of the solder balls are coplanar to form a substantially flat mounting interface, so that in the final application the balls will reflow and solder evenly to a planar printed circuit board substrate. Any significant differences in solder coplanarity on a given substrate can cause poor soldering performance when the connector is reflowed onto a printed circuit board. To achieve high soldering reliability, users specify very tight coplanarity requirements, usually on the order of 0.1 mm (0.004 inches). Coplanarity of the solder balls is influenced by the size of the solder ball and its positioning on the connector. The final size of the ball is dependent on the total volume of solder initially available in both the solder paste and the solder balls. In applying solder balls to a connector contact, this consideration presents particular challenges because variations in the volume of the connector contact received within the solder mass affect the potential variability of the size of the solder mass and therefore the coplanarity of the solder balls on the connector along the mounting interface.

Another problem presented in soldering connectors to a substrate is that connectors often have insulative housings which have relatively complex shapes, for example, ones having numerous cavities. Residual stresses in such thermoplastic housings can result from the molding process, from the build up of stress as a result of contact insertion or a combination of both. These housings may become warped or twisted either initially or upon heating to temperatures necessary in SMT processes, such as temperatures necessary to reflow the solder balls.

Such warping or twisting of the housing can cause a dimensional mismatch between the connector assembly and the PWB, resulting in unreliable soldering because the surface mounting elements, such as solder balls, are not sufficiently in contact with the solder paste or close to the PWB prior to soldering.

It is an object of the present invention to provide a method for reliably and efficiently mounting high density electrical connectors on substrates by surface mounting techniques and to provide such electrical high density connectors manufactured by such method.

This object is accomplished by a method as claimed in claim 1 and a connector as claimed in claim 5. Dependent claims are directed on features of preferred embodiments of the invention.

Electrical connectors according to the present invention provide high I/O density and reliable attachment to circuit substrates by SMT techniques. These connectors exhibit high coplanarity along the mounting interface.

Electrical connectors of the present invention are ones in which one or more terminals are connectable by a fusible electrically conductive material to a substrate. This fusible electrically conductive material is a solder mass, preferably comprising a solder ball that can be reflowed to provide the primary electrical current path between the terminal and a circuit substrate.

### Brief Description of the Drawings

The method and connector of the present invention is further described with reference to the accompanying drawings in which:
- Fig. 1: is a top plan view of a receptacle connector of a preferred embodiment of the connector of the present invention;
- Fig. 2: is a partially cut away end view of the receptacle shown in Fig. 1;
- Fig. 3: is a top plan view of a plug element of a preferred embodiment of the present invention;
- Fig. 4: is a partially cut away end view of the plug element shown in Fig. 3;
- Fig. 5: is a cut away end view of the receptacle and plug shown in Fig. 1 - 4 in unmated relation;
- Fig. 6: is an end view of the receptacle and plug shown in Fig. 5 in mated relation;
- Fig. 7a, 7b and 7c: are cut away end views showing respectively first, second and third sequential stages in the mating of the receptacle end plug shown in Fig. 5;
- Fig. 8: is a bottom plan view of the receptacle shown in Fig. 1 before the placement of solder balls thereon;
- Fig. 9: is a bottom plan view of the receptacle shown in Fig. 8 after placement of the solder balls thereon;
- Fig. 10: is a detailed cut away view of area XII in Fig. 1;
- Fig. 11: is an enlarged view of the cut away area in Fig. 4;
- Fig. 12: is an enlarged view of the cut away area in Fig. 10;
- Fig. 13: is an enlarged cross sectional view through XIII - XIII in Fig. 1,
- Fig. 14: is a top plan view of a second preferred embodiment of a receptacle connector of the present invention;
- Fig. 15: is an end view of the receptacle shown in Fig. 14;
- Fig. 16: is a top plan view of a second preferred embodiment of a plug connector of the present invention;
- Fig. 17: is an end view of the plug shown in Fig. 16;
- Fig. 18: is an end view of the mated receptacle and plug shown in Fig. 14 - 17;
- Fig. 19: is a top plan view of a receptacle used in a third preferred embodiment of a receptacle connector of the present invention;
- Fig. 20: is an end view of the receptacle shown in Fig. 19;
- Fig. 21: is a top plan view of the plug element of the third preferred embodiment of a plug connector of the present invention;
- Fig. 22: is an end view of the plug element shown in Fig. 21;
- Fig. 23: is an end view of the mated receptacle and plug shown in Figs. 19 - 22;
- Fig. 24a and 24b: is a graph showing temperature versus time and distance during solder reflow in Examples 1 and 2 of the method of the present invention;
- Fig. 25a - 25f: are laser generated profiles of the product of Example 3 of the method of the present invention;
- Fig. 26a and 26b: are x-ray photographs showing the product of Example 4 of the method of the present invention;
- Fig. 26c and 26d: are electron microscope photographs showing the product of Example 4 of the method of the present invention.
- Fig. 27: is a view similar to Fig. 10 in which the ground and power contacts have been omitted;
- Fig. 28: is a view similar to Fig. 27 with a contact securing arrangement;
- Fig. 29: is a computer generated representation of predicted stresses in an insulative housing similar to those illustrated in the preferred embodiments of the present invention;
- Fig. 30: is a graph of contact retention force as a function of the amount of deformation (compression) in a rib of the insulative housing as is shown in Fig. 27;
- Fig. 31: is a front elevational view of a receptacle signal contact used in a preferred embodiment of the connector of the present invention;
- Fig. 32: is a front elevational view of a plug signal contact used in a preferred embodiment of the connector of the present invention;
- Fig. 33: is a front elevational view of a receptacle ground/power contact with carrier strip used in a preferred embodiment of the connector of the present invention; and
- Fig. 34: is a front elevational view of a plug ground/power contact with carrier strip used in a preferred embodiment of the connector of the present invention.

### Detailed Description of the Preferred Embodiments

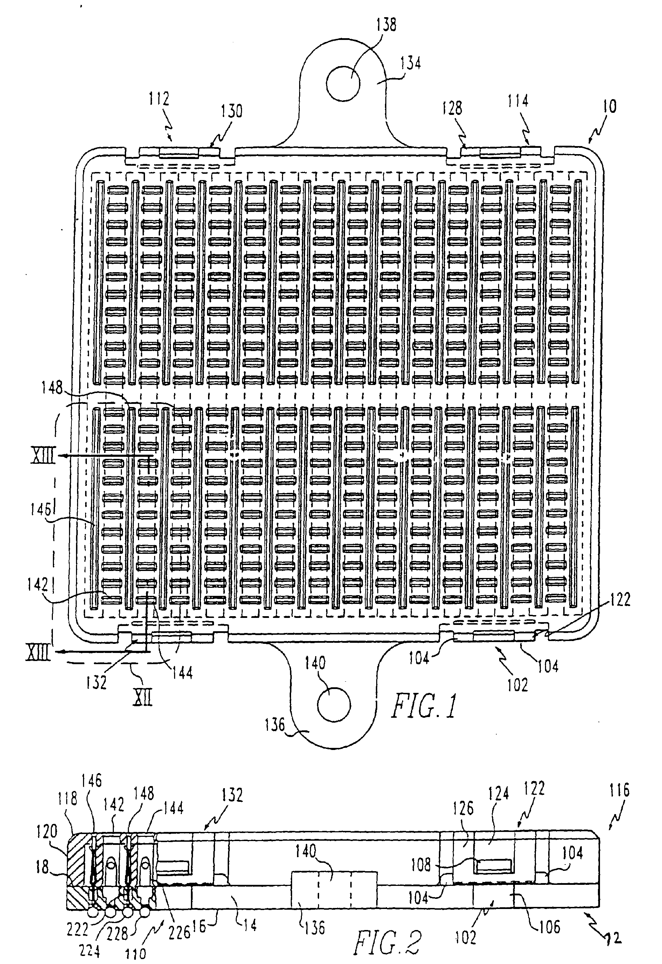

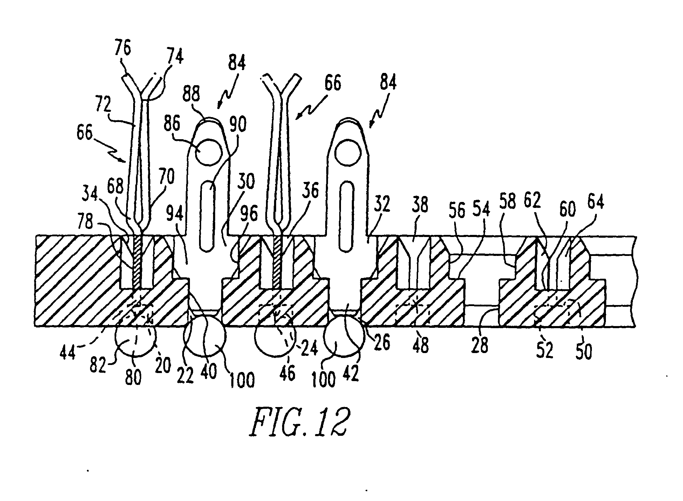

Referring generally to Fig. 1 - 2 and 12 - 13, a set of intermating connectors according to a first embodiment of a high density connector of the present invention includes a receptacle which is shown generally at numeral 10. A base of the receptacle is shown generally at numeral 12. The base is preferably formed by molding an appropriate insulating polymeric material capable of withstanding SMT reflow temperatures, for example, liquid crystal polymer (LCP). Referring first to the base, this element includes a base wall 14 having an exterior side 16 and an interior side 18. On the exterior side there are outer recesses as, for example, recesses 20, 22, 24, 26 and 28 (Fig. 12). On the interior side there are inner contact receiving recesses as, for example, recesses 30, 32, 34, 36 and 38. Connecting these inner and outer recesses are medial slots as, for example, slots 40, 42, 44, 46 and 48. Each of the outer recesses has a base wall and a lateral wall as, for example, base wall 50 and lateral wall 52 (Fig. 12). Each of the inner signal contact receiving recesses has a base wall and intersecting lateral walls as, for example, base wall 54 and lateral walls 56 and 58. Each of the inner ground or power contact receiving recesses also has a base wall and diagonal lateral walls as, for example, base wall 60 and lateral walls 62 and 64. The above described inner and outer recesses and connecting medial slots receive ground/power contacts or signal contacts.

The ground or power contacts preferably have an upper section, shown generally at numeral 66, formed of two contacting forks 68 and 70. Each of these forks has a converging section 72, a contact point 74 and an outwardly diverging or lead-in section 76. The ground or power contacts also include a medial section 78 passing through the lower wall of the receptacle and a lower section 80 that extends into the outer recess. A solder ball 82 is fused onto lower section 80, as will be described below.

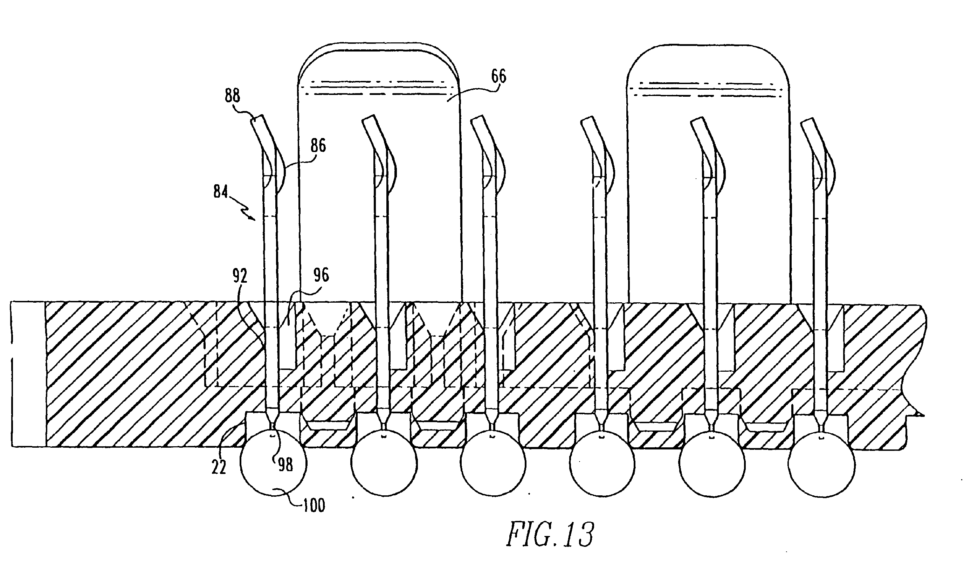

Each of the signal contacts (Fig. 12 and 13) includes an upper section shown generally at numeral 84 preferably having a contact projection 86, a lead-in bend 88 and a stiffening rib 90. The signal contacts also include a medial section 92 which passes through the lower wall of the receptacle. Each signal contact includes a lower section 98 (Fig. 13) extending into the outer recess for example, recess 22 in Figs. 12 and 13, where a solder ball 100 is fused to lower section 98 as will be explained below.

Referring particularly to Fig. 1 - 2, the base section of the receptacle includes latching structures, for example, as is shown generally at numeral 102. This latching structure includes an upward tab 104 which is superimposed over a vertical groove 106 and which has an outward projection 108. The base section of the receptacle also has other similar latching structures 110, 112 and 114. The receptacle also includes an upper section shown generally at 116 which is superimposed over the base section. This upper section has a top wall 118 and a peripheral side wall 120. This upper section is fixed to the base section by means of latching structures as is, for example, shown generally at numeral 122. Each of these latching structures has a side wall recess 124 and a U-shaped latch 126 which extends downwardly from the top wall and is spaced from the side wall recess. The upward tab 104 fits between the U-shaped latch 126 and the side wall recess 124 to enable the U-shaped latch to engage the outward projection 108 on the latching structure 102 of the base section. The upper section includes other similar latching structures 128, 130 and 132 which engage, respectively, latching structures 110, 112 and 114 on the base. The upper section 116 or the latching structure 102 also may have mounting brackets 134 and 136 which have fastener apertures 138 and 140, respectively. On the top wall 118 of the upper section 116 there are also signal contact access apertures as, for example, apertures 142 and 144. These access apertures are arranged in a plurality of rows corresponding to the rows of signal contacts in the base section. Interposed between these rows of signal contact access apertures are elongated ground or power contact access slots as, for example, slots 146 and 148. The upper section 116 forms a mating interface between receptacle 10 and a mating plug 150 described below.

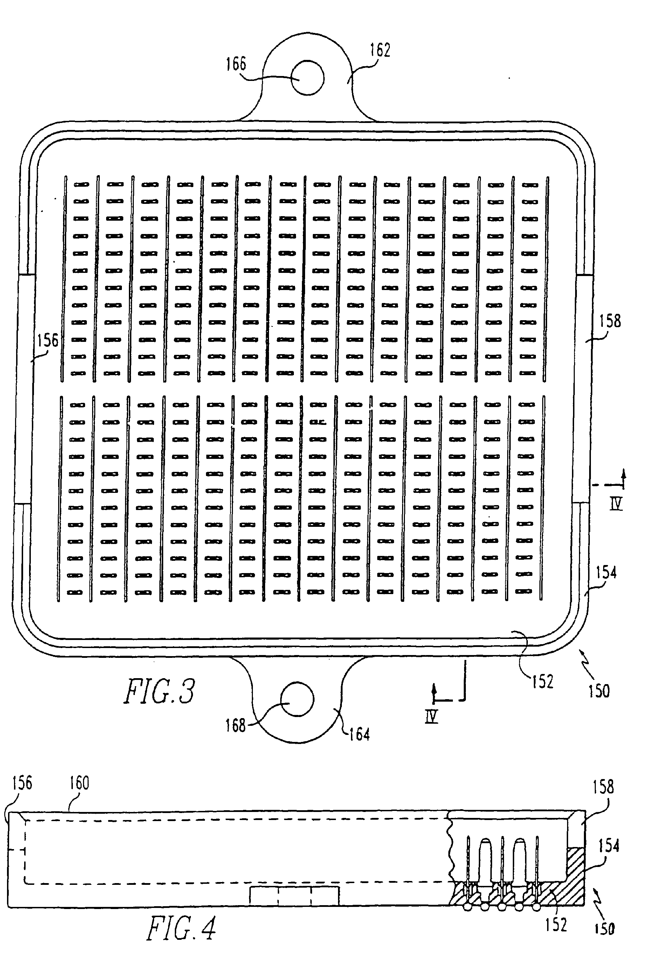

Referring to Fig. 3 - 4 and Fig. 11, the mating plug of the connector is shown generally at numeral 150. The plug includes an insulative base wall 152 and a peripheral side wall 154. There are opposed gaps 156 and 158 in the side wall and there is an open side 160 in opposed relation to the base wall. Projecting laterally from the plug are mounting brackets 162 and 164 having fastener receiving apertures 166 and 168 respectively, that are alignable with the fastener receiving apertures 138, 140 in the mounting brackets of the receptacle.

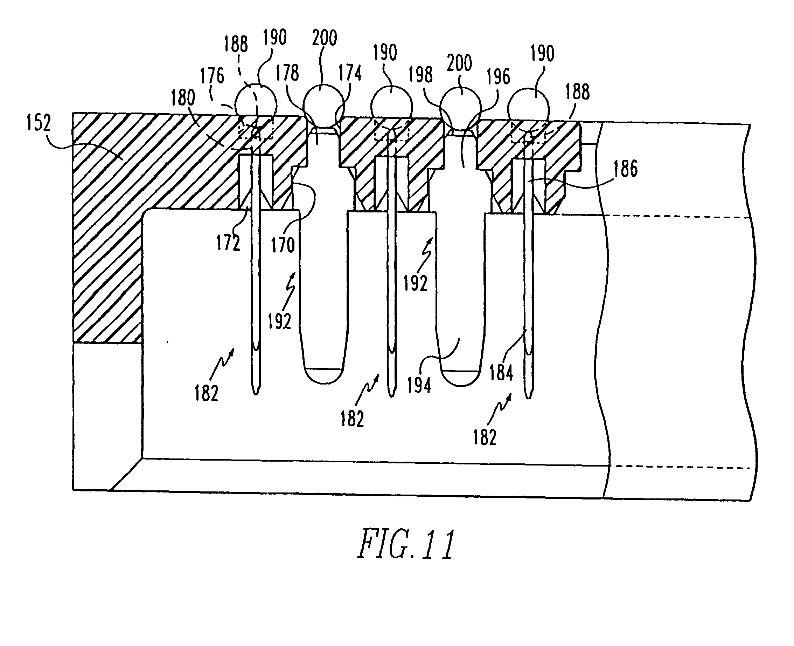

Referring to Fig. 11, on the inner side of the base wall 152 there are inner signal contact receiving recesses such as recess 170. Also on the inner side of the base wall are inner power or ground contact receiving recesses such as recess 172. In opposed relation to the outer recesses on the base wall there are outer signal contact receiving recesses such as recess 174, and outer power or ground contact receiving recesses, as at recess 176. Connecting the outer and inner signal contact receiving recesses and the outer and inner power or ground contact receiving recesses are, respectively, medial slots 178 and 180. Mounted in the power/ground contact receiving recesses via the medial slots 180 are power or ground contacts, shown generally at numeral 182. Each contact 182 has an elongated inner section 184, an elongated medial section 186, which is mounted in base wall 152, and an outer section 188 extending into recess 176. A solder ball 190 is fused onto section 188. The outer section 188 and the solder ball are partially contained in the outer recess 176. The plug also includes a plurality of signal contacts 192. These signal contacts each have an inner section 194, a medial section 196 mounted in the base wall, and a terminal tab 198 extending into recess 174. A solder ball 200 is fused onto terminal tab 198. Again it will be observed that this outer section and the solder ball are partially contained in the outer recess as at 170.

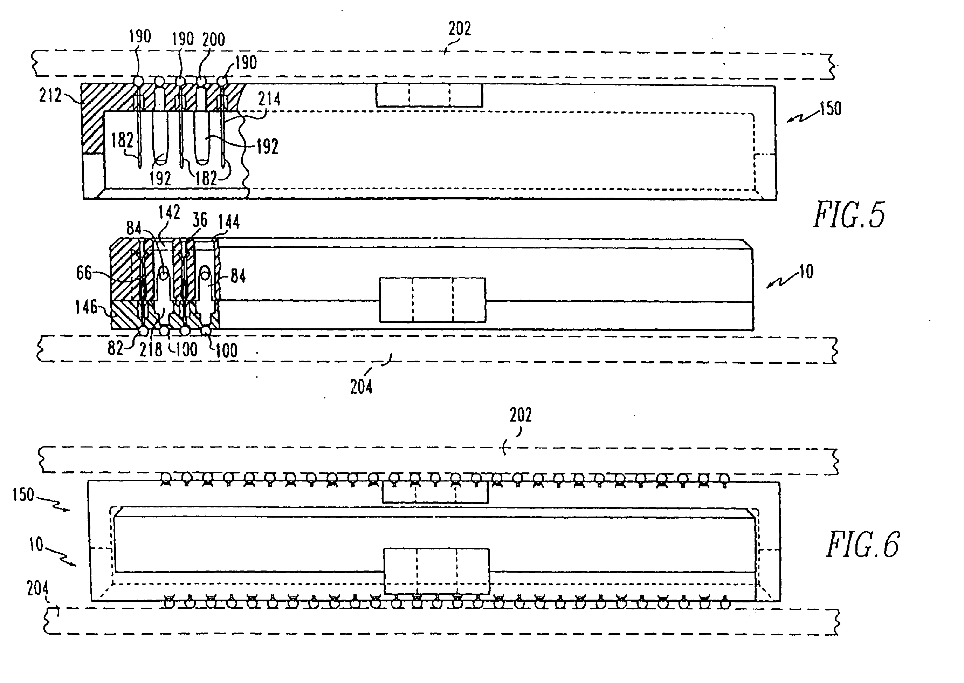

Referring to Fig. 5 - 7c, it will be seen that the plug described above is mounted on a circuit substrate, such as a rigid PWB 202, and the receptacle is mounted on a similar PWB 204. The plug and receptacle thereby form a board to board interconnection, as illustrated in Fig. 6. The plug has a two dimensional array of signal contacts, such as 192 onto which are fused solder balls 200 and a plurality of ground/power contacts, such as contacts 192, onto which are fused solder balls 190. By use of SMT techniques, the solder balls are also fused to the PWB 202 to fix the entire plug to the PWB and effect electrical contact between the signal contacts and ground or power contacts in the plug and the PWB. It will be appreciated that although not all contacts are illustrated in Fig. 5, all such contacts are connected to solder balls and to the PWB in the same way. Similarly, solder balls 100 are fused onto receptacle signal contacts 84 and those solder balls are fused to the PWB 204. Receptacle ground/power contacts 66 are mounted in slot 34 and are fused to solder balls 82 and these solder balls are fused to PWB 204.

The plug is aligned with the receptacle so that the peripheral side wall 154 of the plug overlaps the peripheral side wall 120 of the top wall 118 of the receptacle.

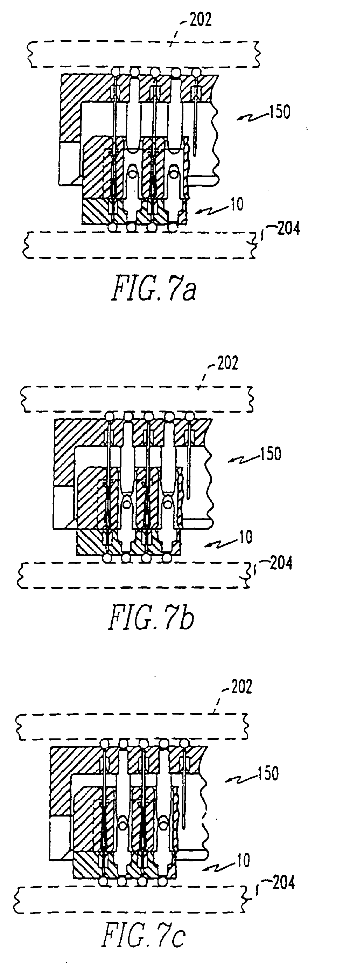

Referring particularly to Fig. 7a - 7c the engagement of the plug and receptacle is shown in greater detail. Fig. 7a shows, after initial alignment, the ground/power contacts in the plug initially entering the ground/power contact receiving slots in the receptacle and engaging the corresponding power/ground contacts in the receptacle. The signal contacts have entered the signal contact slots in the receptacle. Fig. 7b shows the signal contacts in the plug initially engaging the corresponding signal contacts in the receptacle and the power/ground contacts in the plug becoming further engaged between the opposed leaves of the power ground contacts in the receptacle. Fig. 7c shows that the signal contacts in the plug being fully engaged with the signal contacts in the receptacle. The power/ground contacts in the plug have become positioned at the base of the fork of the power/ground contacts in the receptacle.

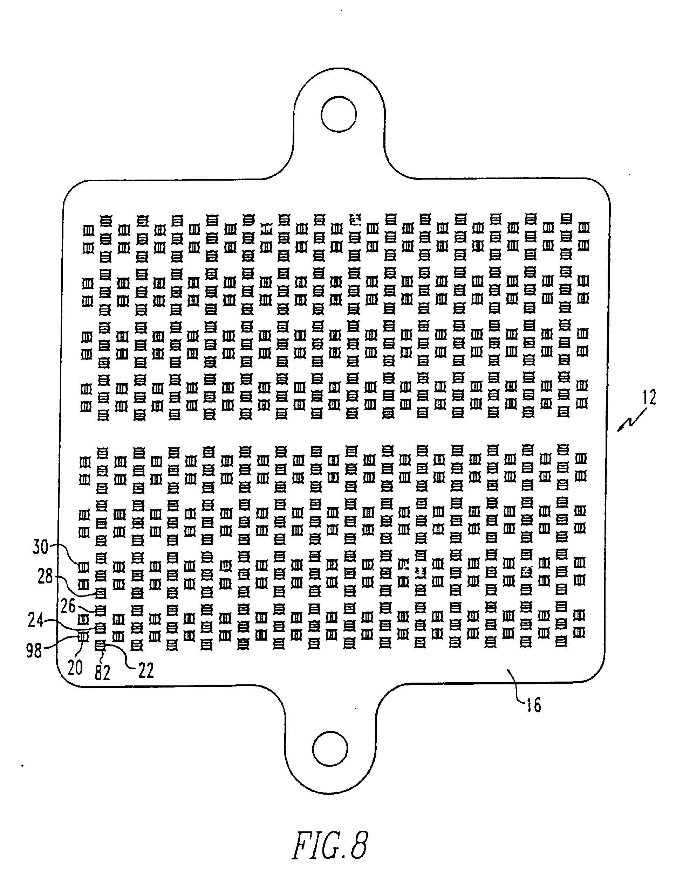

Referring to Fig. 8, the exterior side 16 of the insulative base 12 of the receptacle is shown prior to the application of the solder balls 82. Prior to the application of the solder balls, the terminal tabs of the signal contacts, and of the power ground contacts, for example lower section 98, are disposed within corresponding outer recesses for example, outer recesses 20, 22, 24, 26 and 28, by insertion of the contacts into the opposite surface 18 of the base 12. A quantity of solder paste of appropriate composition is applied to substantially fill each outer recess. The solder balls are then applied over the outer or mounting surface of the base.

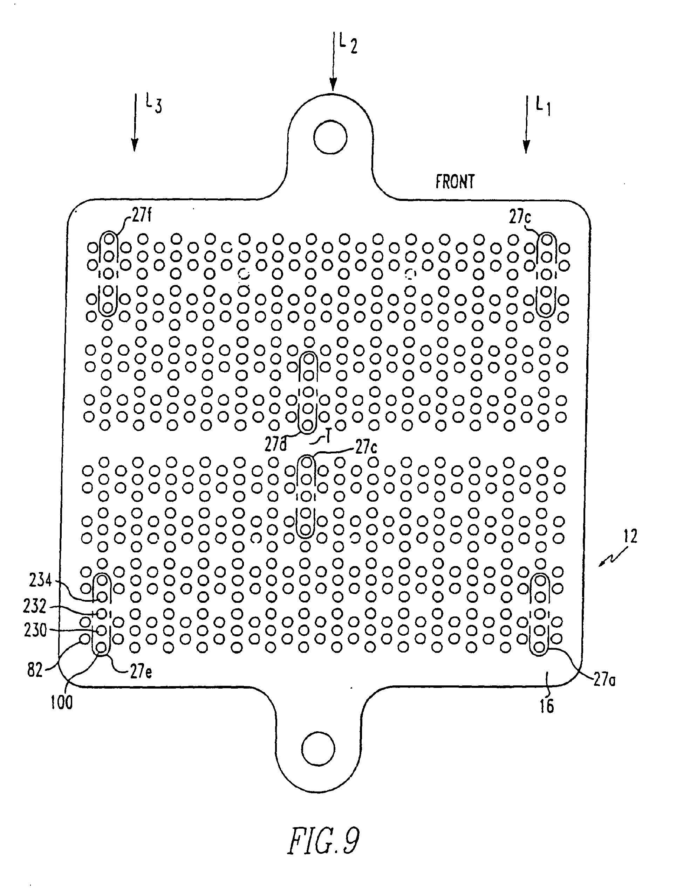

Preferably, the outer recesses are smaller in transverse extent than the solder balls, so that the solder balls are supported on the edges of the recesses, at a position near the terminal tabs of the contacts. To maximize the stability of the solder ball in the recess, a recess that is round or the shape of a regular polygon in cross-section is preferred. The solder paste aids in holding a solder ball in each of the exposed recesses as is shown in Fig. 9, where, for example, solder ball 82 is shown in recess 20 and solder ball 100 is shown in recess 22. Additional solder balls, 230, 232 and 234 are shown, for example, in recesses 24, 26 and 28. A solder ball will be positioned in all of the outer recesses of the receptacle. It will also be understood that the exterior side of plug will be substantially identical to the exterior side of the receptacle before placement of the solder balls as is shown in Fig. 8 and after emplacement of the solder balls as is shown in Fig. 11. After emplacement of the solder balls in the outer recesses, the connector is subjected to a reflow process to fuse the solder balls onto the terminal tabs. The exterior sides of the connectors, together with the solder balls and particularly the outer surfaces of the solder balls, form a substantially planar mounting interface, along which the connector is mounted onto a supporting circuit substrate, such as a PWB.

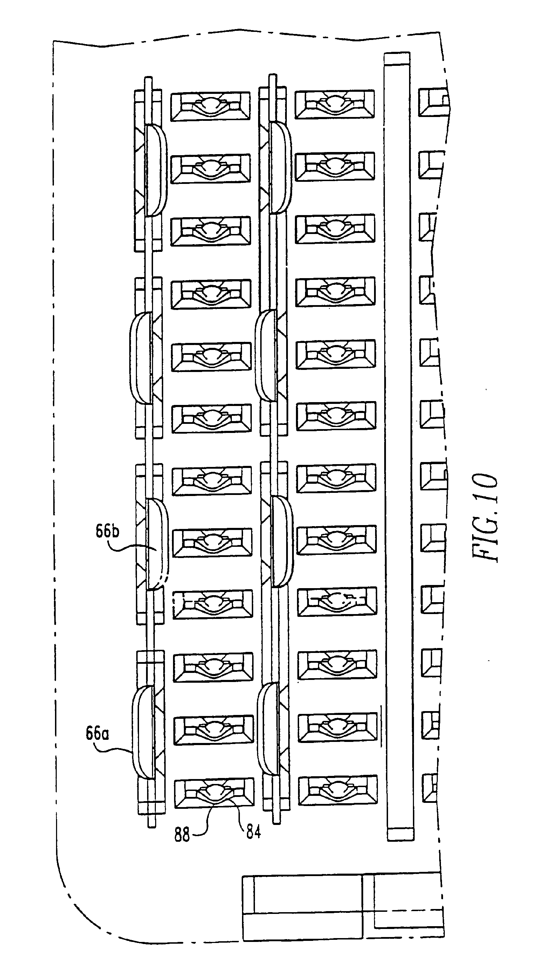

Fig. 10 and 13 show a variant of the Fig. 1 embodiment wherein, instead of the forked receptacle contacts 66, oppositely disposed pairs 66a and 66b of blade type contacts engage the ground/power contacts 182.

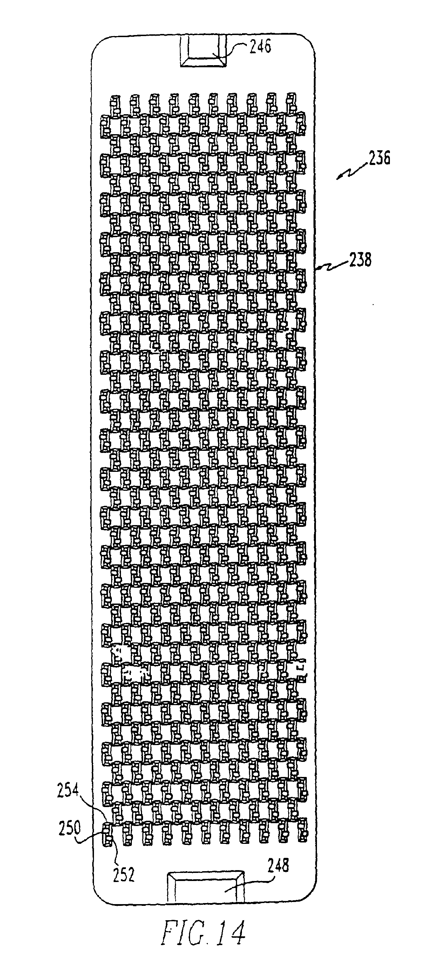

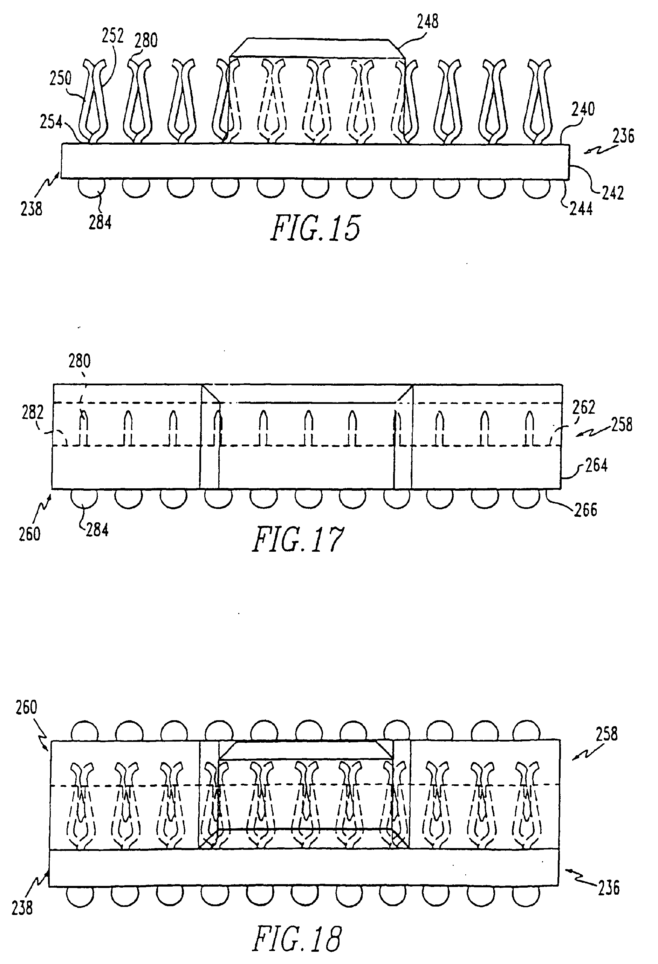

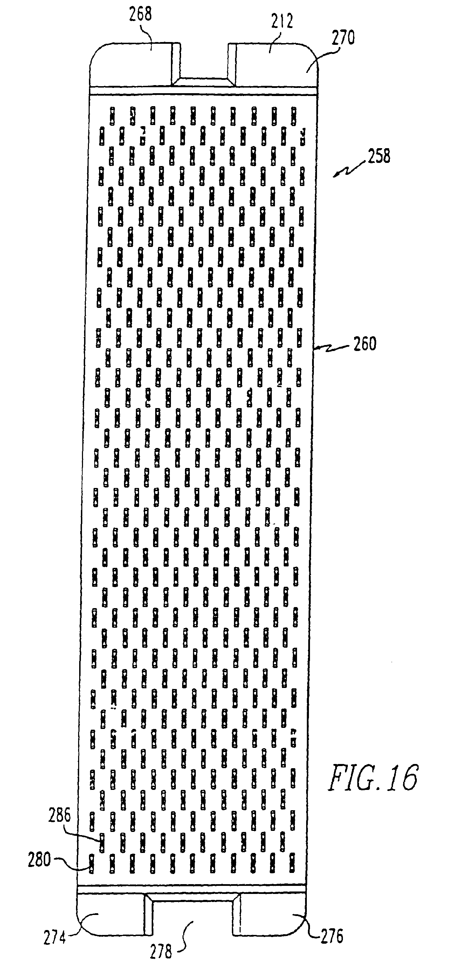

Fig. 14 - 18 illustrate a second preferred embodiment of a set of intermating connectors of this invention. Referring particularly to Fig. 14 - 15, this set includes a receptacle shown generally at numeral 236. This receptacle includes an insulative housing shown generally at 238 which has an inner side 240, a lateral side 242 and an exterior side 244. The housing also includes opposed alignment projections 246 and 248. On the inner side of the housing there are contacts 250 and 252 each having sections which bow away from each other and then converge to a contact point from which then again diverge. Contacts 251 are mounted on base 231 in the same manner as the embodiments shown in Fig. 1 - 13. Solder balls, such as solder ball 254, are mounted to the board side of contacts 250 and 252 in the same manner as described above. Referring particularly to Fig. 16 and 17, the set also includes a plug shown generally at 258 which includes an insulative housing shown generally at 260 having an inner side 262, a peripheral lateral side 264 and an exterior side 266. At one end of the housing there are a pair of vertical end walls 268 and 270 with a medial end recess 272. At the opposed end of the housing there are another pair of end walls 274 and 276 with a medial end recess 278. Extending from the inner side of the housing there are a plurality of contacts as at contact 280 that extend from recesses as at 282. Onto each of these contacts is fused a solder ball 284. It will also be seen that these contacts are positioned in a staggered arrangement. For example, contact 286 is offset with respect to contact 280, so rows of contacts can be spaced closer together to increase contact density. Referring particularly to Fig. 18, it will be seen that each contact in the plug such as contact 280 is vertically aligned with one of the pairs of converging contacts, such as contacts 250 and 252, in the receptacle and is interposed between these converging contacts. It will also be seen that the alignment projections 246 and 248 also engage the end recesses 272 and 278 in the plug. In this embodiment the separate ground/power contacts used in the Figs. 1 - 13 embodiment are not present. Such functions can, if desired, be incorporated into the undivided contacts pairs.

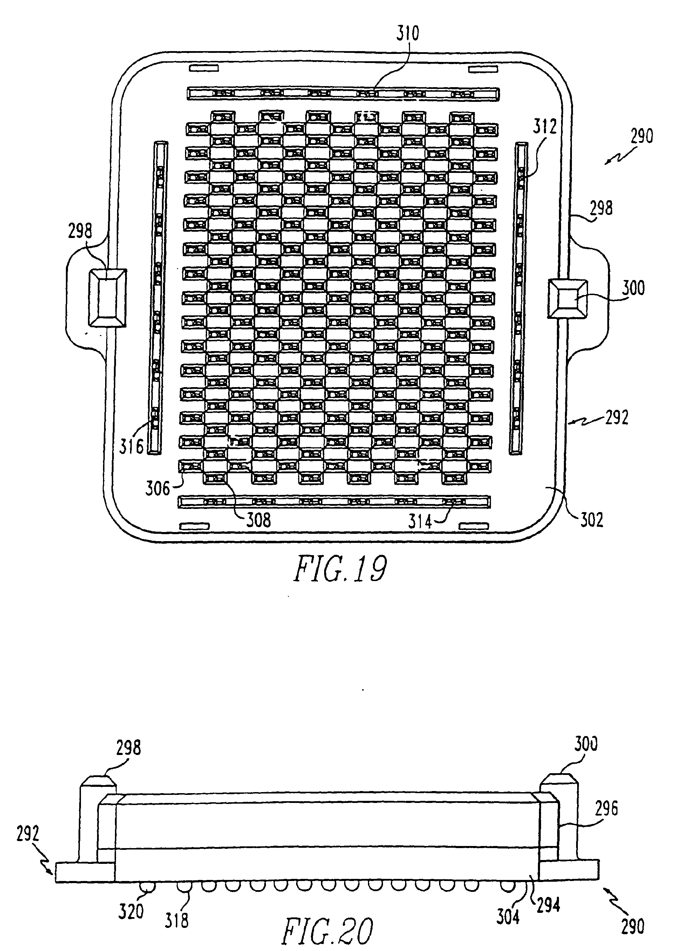

Fig. 19 - 23 show a third preferred embodiment of a set of intermating connectors. The plug is shown generally at numeral 290. This plug includes a housing generally 292 having a base wall 294 and a peripheral lateral wall 296, as well as opposed alignment projections 298 and 300. The base wall of the housing has an inner side 302 and an outer side 304. Signal contacts, such as contact 306, extend from inner side 302. It will be seen that the signal contacts are also staggered or offset in alternate rows, to increase contact density. The plug also includes ground or power contacts 310, 312, 314 and 316 arranged adjacent each of the sides of the plug parallel to one side of the lateral wall. On the exterior side of the base wall are signal contact solder balls, such as solder ball 318, and power ground contact solder balls, such as 320, which are fused to their respective contacts in the same way as described with respect to the first embodiment. The receptacle is shown generally at numeral 322 and has an insulative housing 324 that includes a base wall 326, a peripheral lateral wall 328 and alignment projection receiving recesses 330 and 332. The base wall also has an exterior side 334 and an inner side 336.

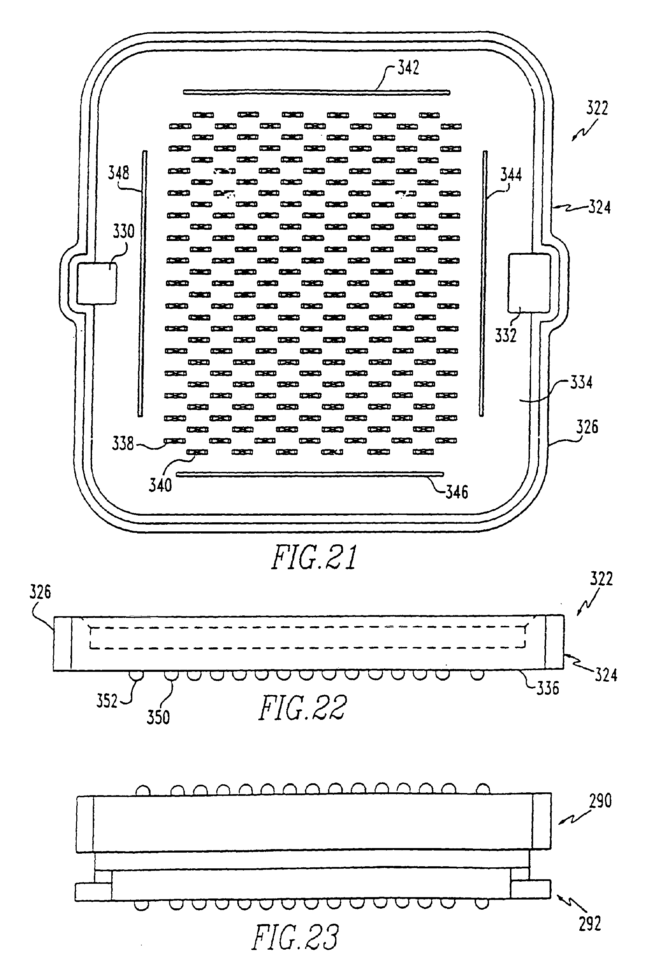

Projecting from the inner side are signal contacts such as contacts 338 and 340. The contacts in adjacent transverse rows are also axially offset to allow an increase in contact density. Parallel to each side of the peripheral wall there are lateral power or ground contacts 342, 344, 346 and 350. On the exterior side of the base wall there are for each signal contact a solder ball, such as solder ball 352. There are also solder balls, such as at solder ball 354, for attaching each of the power or ground pins. Referring particularly to Fig. 23, it will be seen that at the plug 290 engages receptacle 322.

As previously mentioned, components such as electrical connectors, that are to be mounted on circuit substrates by SMT techniques must meet very demanding specifications for coplanarity. If tight tolerances on coplanarity, usually on the order of about 0.076 mm to 0.081 mm (0.003 to about 0.004 inch), are not maintained, manufacturers experience undesirably high failure rates resulting from faulty solder connections. Variations in the distance of a surface mount portion of a contact from the circuit substrate can result from variations in the location of the contact in the insulative housing occurring as a result of the contact insertion process and from deformation of the housings, resulting in bowing or warping of the mounting interface of the connector body. Connectors made in accordance with the present invention are capable of attaining strict coplanarity requirements by use of features that carefully locate and size the fusible bodies used for bonding the connector to a substrate and by the use of contact securing arrangements that prevent accumulations of stresses in the connector housing that tend to distort the housing.

In the embodiments of Fig. 1 - 23 the metal contacts are secured in insulative housings in a manner to avoid the inducing of stress in the body of the housing. This securing is achieved by the use of a shaped slot or opening into which a securing portion of the contact is inserted. In one arrangement especially useful for the smaller signal contacts, the slot has a shape that closely conforms in shape and dimensions to all the surfaces of the contact but one. The wall of the slot facing that one surface has an integrally molded lateral projection projecting into the slot. The distance between the distal end of the projection and the opposing wall of the slot is less than the thickness of the contact.

Thus the distal portion of the projection is engaged by and deformed by the contact as it is inserted into the slot. The contact is held securely in the slot by the normal force exerted on the contact by the deformable projection. Because the distal of the projection is free to deform, the build up of stresses in the housing is avoided. In the preferred embodiments illustrated, the projection comprises a pyramidal rib integrally formed on one of the side walls of the slot.

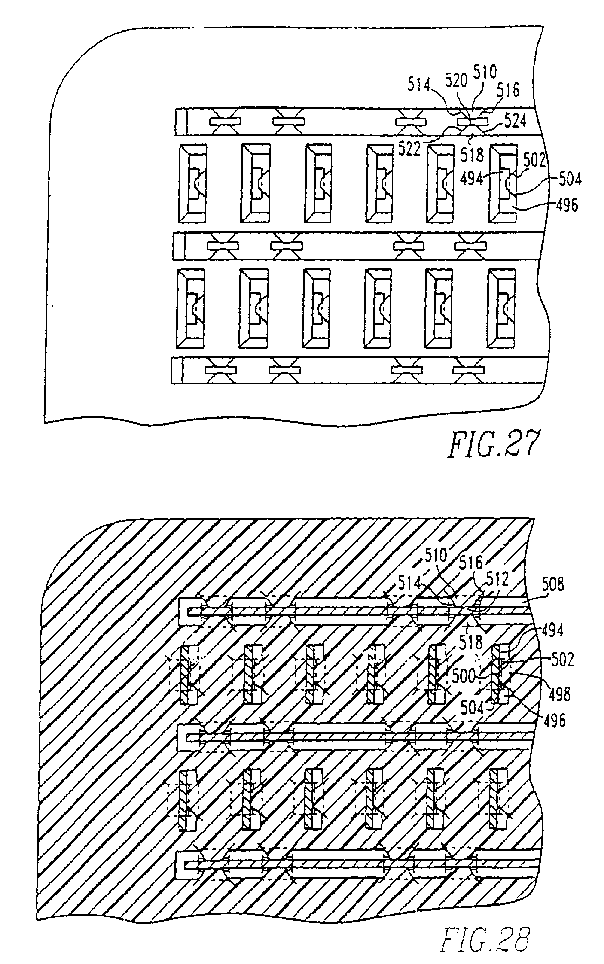

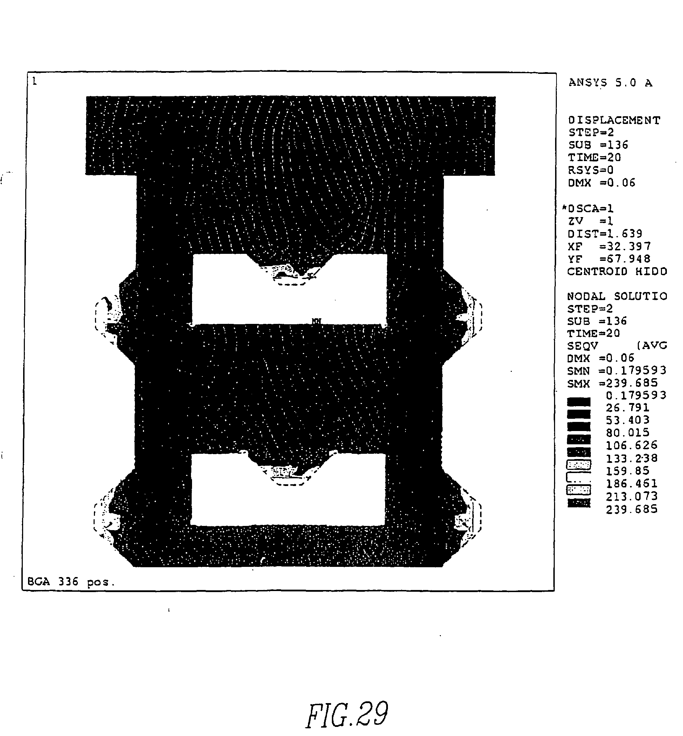

The specific rib configuration illustrated is believed to be optimum for the particular housings in which it is employed, but other similar ribs of somewhat different shape or size might be advantageously employed with other types of housings. Referring particularly to Fig. 27 and 28, a signal contact 494 is retained in slot 496 and abuts against rib 498. The rib has a planar surface 500, where it engages the signal contact 494, and opposed oblique sides 502 and 504. The contact 494 is securely retained in the slot by engagement with the back and side edges of the slot 496 and rib 498. The portion of the rib adjacent surface 500 is free to deform as contact 494 is forced into slot 496, thereby relieving any stresses that result from contact insertion.

Similarly, a power/ground contact is retained in slot 508 and bears against deformable rib 510. The rib has a distal portion 512, where it abuts against the contact, and opposed oblique sides 514 and 516. In this arrangement, there is also an opposed rib as, for example, rib 518. This opposed insulative rib also has a distal portion 520 and oblique sides 522 and 524. The opposed deformable ribs can be used for securing larger contacts and for centering the contact in the slot.

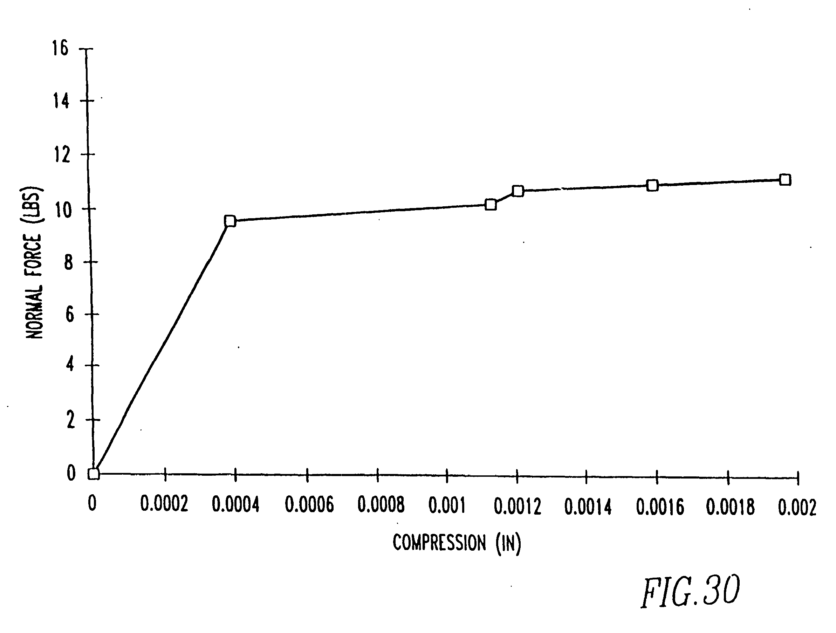

Those skilled in the art will also appreciate the particular shape, size, number and placement of such ribs may vary for different types of housings, and these factors would be selected so that, to the greatest extent possible, stresses in the housing are isolated in the deformable ribs. Fig. 29 which was generated using ANSYS stress analysis software available from Ansys, Inc. of Houston, Pennsylvania shows that by use of the contact securing arrangement illustrated in Figs. 27 and 28, high levels of stress are essentially isolated in the ribs, and do not extend substantially beyond the contact mounting slots thereby significantly reducing the risk of warpage or twisting of the housing which could otherwise result from a large number of contact insertions. The units for the various stress areas shown in Fig. 29 is N/mm² and the mm is the unit for displacement shown. Fig. 30 shows that, for a typical contact 494, increases in deformation (compression) of the distal portion of the deformable rib up to about 0.01 mm (0.0004 inch) resulted in an increasing retention force between the contact and the housing, resulting from the normal force imparted on the contact by the rib. After 0.01 mm (0.0004 inches) of deformation (compression), only minor increases in retention force resulted.

As previously mentioned, another factor influencing coplanarity of the substrate mounting face of a connector utilizing BGA mounting is the uniformity of the size of the solder balls and the position of the solder balls with respect to the board mounting face of the connector housing. In the preferred embodiments previously described, the termination tab of each contact is positioned in a recess. The outer recesses are substantially uniform in size and shape. These recesses provide several features of importance with respect to the present invention. The recesses can receive a highly uniform amount of solder paste placed therein, for example, by a simple deposit and squeegee operation. Thus the amount of solder available for securing each solder ball onto a contact is substantially uniform. The recesses locate the position of each solder ball in the lateral X - Y directions prior to attachment of the solder balls onto the contacts. The recesses also locate the solder balls in the Z direction with respect to the bottom surface of the housing and the distance of the solder ball from the terminal tabs of the contacts. The nominal extension of the tab into the recess is set so that at the maximum of the tolerance for extension of the tab into the recess, the tab does not touch the solder ball and thereby influence its Z direction location. However, fusing of the solder ball onto the contact tab is assured by having a relatively uniform and adequate amount of solder, from the solder paste, in the recess. Any variation in the distance between the contact tab and the solder ball is absorbed by the variable volume of solder paste placed in the recess.

In order to maintain an adequate amount of solder adjacent the solder ball during the reflow step used to attach the solder balls onto the contacts and to prevent solder wicking onto the engagement surfaces of the contact, the contact is treated to resist solder wicking.

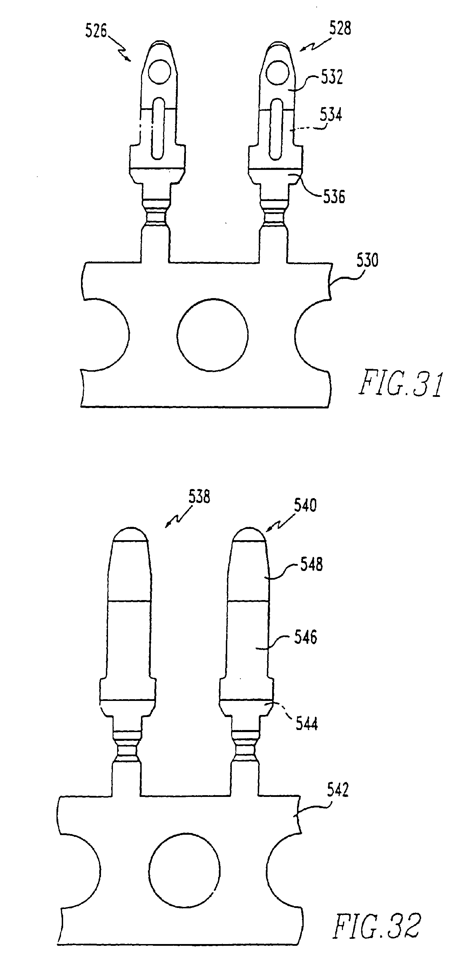

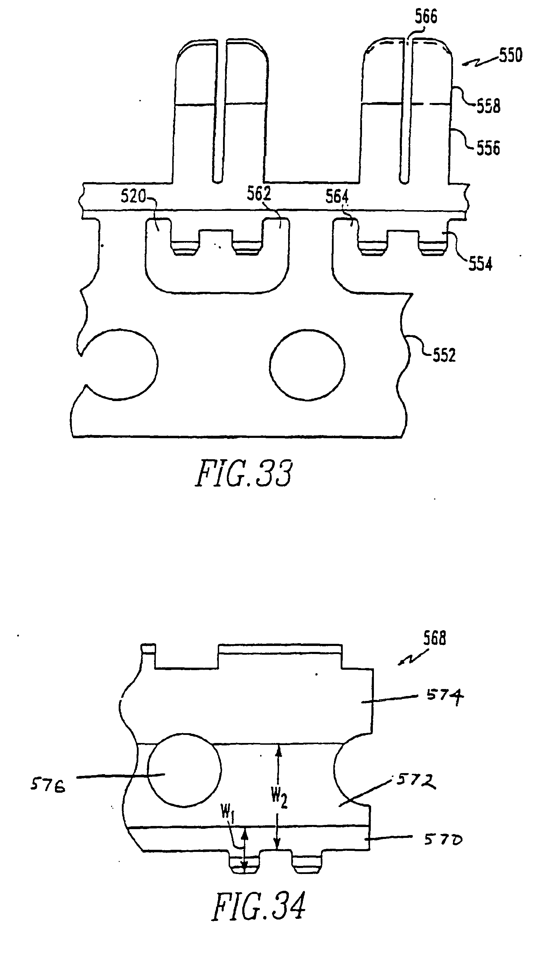

Referring particularly to Fig. 31, contacts 526 and 528 are shown attached to a carrier strip 530. The contacts have a contact engagement area 532 usually plated with non-oxidizing metals such as gold, palladium or alloys of palladium. The contacts also have a central area 534, a portion of which forms the contact retention area in the housing. An anti-solder wicking or non-solder wettable material is applied to the central engagement area 532. One preferred material for this purpose is nickel plating. While not intending to be bound by any particular theory, it is believed that the solder resistant feature of this nickel plated area results from or is enhanced by the oxidation of the nickel after plating, for example, by exposure to ambient air for several days. Surprisingly and unexpectedly, it is found that the nickel or nickel oxide barrier prevents or reduces solder wicking in such contacts. For the nickel or nickel oxide plating to have such a passivation function, it is preferred that the plating have a thickness of from 254 µmm to 2540 µmm (10 µin to 100 µin) and more preferably about 50 mm. Other solder wick resistant materials are believed to be usable for this purpose, such as flourine containing solder resist coatings. These may be especially useful if the entire contact is plated with a continuous outer layer of a solder wettable metal, for example, gold. The contact tab area 536 may preferably be plated with a solder receptive material such as gold, tin or tin alloys. Preferably the entire contact will be plated with nickel. On the upper section there is a precious metal layer selectively plated over the nickel. This upper section precious metal plating will preferable have a thickness of from 254 µmm to 2540 µmm (10 µin to 100 µin) and more preferable 7620 µmm (30 µin). On the lower section there is a solder wettable metal layer selectively plated on the lower section. Alternatively, an electroplated layer of chromium can be substituted for the nickel layer. Referring to Fig. 32, plug signal contacts 538 and 540 are shown attached to a carrier strip 542. Each of these contacts has a gold plated tab area 544, a nickel plated central retention and anti-wicking area 536 and a precious metal plated engagement area 548. Similarly in Fig. 33, the ground/power contact 550 is shown attached to carrier strip 552. This contact has a lower gold plated tab area 554, a nickel plated central anti-wicking area 556 and an upper gold plated contact engagement area 558. Another feature of ground/power contact 550 which is also found to reduce wicking is a series of notches in the tab area 554 such as notches 560, 562 and 564. Another feature of ground/power contact 550 which was included in embodiments disclosed above is vertical slots such as slot 566. Referring to Fig. 34, a plug ground/power contact 568 is shown which has a lower gold plated tab area 570, a nickel plated central anti-wicking area 572 and an upper gold plated area 574. It will be seen that ground/power contact 568 does not have a separate carrier strip, but it does have apertures such as aperture 576 which allow the contact itself to serve this carrier function. With each of the contacts described above it will be understood that tin or other solder wettable material may be substituted for gold in the lower area. For all the contacts shown in Figs. 31 - 34 the width of the lower gold plated tab area as is, for example, shown at w₁ in Fig. 34 will preferably be from about 0.1mm to about 0.25mm. The width of the nickel plated central area as is shown, for example, at w₂ in Fig. 34 will preferably be from about 0.1mm to about 1mm.

In the method of this invention the conductive element will preferably be a solder ball. Those skilled in the art, however, will appreciate that it may be possible to substitute other fusible materials which have a melting temperature less than the melting temperature of the insulative body. The fusible element can also have a shape other than a sphere. The solder ball or other conductive element will also preferably have a diameter which is from about 50 percent to 200 per cent of the width of the recess. This diameter will also preferably be related to the depth of the recess and be from 50 percent to 200 per cent of that depth. The volume of the solder ball will preferably be from about 75 percent to about 150 percent of the volume of the recess and, more preferably, will be about the same volume as the recess. The contact tab will extend into the recess by a sufficient amount to present adequate surface area for the solder ball to fuse to, and will usually preferably extend into the recess from about 25 percent to 75 percent and more preferably to about 50 percent of the depth of the recess as previously mentioned. The recesses ordinarily will be circular, square or the shape of any other regular polygon in cross section. When the conductive element is solder, it will preferably be an alloy which is in the range of about 90%Sn and 10%Pb to about 55%Sn and 45%Pb. More preferably the alloy will be eutectic which is 63%Sn and 37%Pb and has a melting point of 183°C. Typically, a "hard" solder alloy with a higher lead content would be used for mating to materials such as ceramics. The "hard" solder ball will "mushroom" or deform slightly as it softens under typical SMT conditions, but will not melt . A "soft" eutectic ball is used for attachment to PCB's and will usually reflow and reform itself under typical SMT conditions.

Other solders known to be suitable for electronic purposes are also believed to be acceptable for use in this method. Such solders include, without limitation, electronically acceptable tin-antimony, tin-silver and lead-silver alloys and indium. Before the solder ball or other conductive element is positioned in a recess, that recess would usually be filled with solder paste.

While it is believed that a solder paste or cream incorporating any conventional organic or inorganic solder flux may be adapted for use in this method, a no clean solder paste or cream is preferred. Such solder pastes or creams would include a solder alloy in the form of a fine powder suspended in a suitable fluxing material. This powder will ordinarily be an alloy and not a mixture of constituents. The ratio of solder to flux will ordinarily be high and in the range of 80% - 95% by weight solder or approximately 80% by volume. A solder cream will be formed when the solder material is suspended in a rosin flux. Preferably the rosin flux will be a white rosin or a low activity rosin flux, although for various purposes activated or superactivated rosins may be used. A solder paste will be formed when a solder alloy in the form of a fine powder is suspended in an organic acid flux or an inorganic acid flux. Such organic acids may be selected from lactic, oleic, stearic, phthalic, citric or other similar acids. Such inorganic acids may be selected from hydrochloric, hydroflouric and orthophosphoric acid. Cream or paste may be applied by brushing, screening, or extruding onto the surface which may advantageously have been gradually preheated to ensure good wetting. Although it has been found that wicking of the solder onto the contact is significantly reduced when a solder paste or cream is used, it is believed that paste type solder flux alone may also be used when a suitable, passivation agent is used. Such a suitable passivation agent would include fluoride containing solder resist coatings such as FLOURAD which is available from the 3M Corporation.

Heating is preferably conducted in a panel infra red (IR) solder reflow conveyor oven. The solder element would ordinarily be heated to a temperature from about 183° to about 195°C but, depending on the material of the housing, solders having melting temperatures may be used. The conveyor oven would preferably be operated at a rate of speed from about 254 mm to 355 mm (10 to 14 inches) per second and would be moved through a plurality of successive heating phases for a total time of about 5 minutes to about 10 minutes. Prior to being inserted into the conveyor oven the connector housing, contacts and solder elements may be preheated at an elevated temperature for at least an hour. In the conveyor oven a temperature profile would be developed based on an appropriate peak temperature, maximum slope and time above reflow temperature. Peak temperature is the highest temperature reached by the housing. For a solder element with a melting point of 183°C, peak temperature would usually be between 185°C and 195°C. Maximum slope is measured in °C/sec and specifies how fast the connector housing temperature is allowed to change, so as to avoid warping or bending. For most applications of this method, maximum positive slope will preferably initially be from about 2°C/sec to 15°C /sec. After the wetting point of the solder is reached negative slope will preferably be -2°C/sec to -15°C/sec. An important aspect of the method of this invention is that time above reflow is minimized. Time above reflow is a measure of how long the solder element remains in its liquid phase. It is found that when time of the solder in its liquid phase is minimized, wicking of solder from the recess up the contact is eliminated or significantly reduced. Preferably rise time of temperature as measured on the board between 180°C and 200°C and fall time of temperature as measured on the board between 200°C and 180°C will both be from about 10 seconds to about 100 seconds. While not intending to be bound by any particular theory, it is believed that during such relatively short periods of time, surface tension of the liquid solder element will restrain the liquid solder from flowing through the contact receiving slot in the base of the recess. After such periods of time, however, the liquid solder will begin to flow through the contact receiving slot and wick up the contact. Prior to bringing the temperature of the solder element to its melting temperature, it may also be advantageous to initially have a relatively high slope but before melting temperature is reached to slow the rate of temperature increase or decrease after which a relatively high slope is then adopted until the melting temperature is reached. The selection of an appropriate housing material may also enhance results. Preferably the housing material will be wholly aromatic liquid crystal polyester (LCP) with characteristics of high glass transition temperature, low thermal coefficient, low moisture absorption, high fracture toughness, good flow and low viscosity, high temperature and high flash point.

The method of the present invention is further described with reference to the following examples.

### Example 1

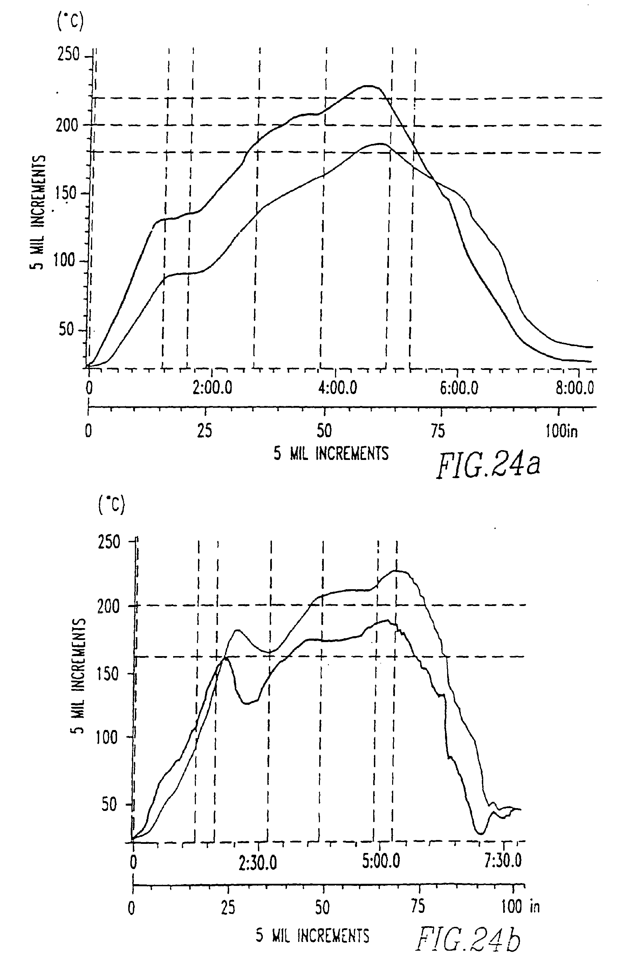

An insulative housing for a connector plug and receptacle substantially is described above in connection with Figs. 1 - 18 was made. Contacts also substantially in accordance with that description were also positioned in the housing. These contacts were beryllium copper and were plated with gold over their entire surface area to a thickness of 30 microns. The housing material was DUPONT H6130 liquid crystal polymer (LCP). The length and width of the plug were respectively 52.5mm (including mounting brackets) and 42.36mm . The recesses on the exterior surfaces of the plug and receptacle housing were cross sectionally square having a side dimension of 0.62mm and a depth of 0.4mm. About 2mm of the contact extended into the recess. Other dimensions were generally in proportion to the above dimensions in accordance with Figs. 1 - 18. On the exterior sides of both the plug and receptacle the recesses were filled or substantially filled with CLEANLINE LR 725 no clean solder cream which is commercially available from Alphametals, Inc. of Jersey City, New Jersey. Both the plug and receptacle were turned over on their exterior sides on a quantity of spherical solder balls so that a solder ball became embedded in each of the recesses. The solder balls used were ALPHAMETAL no flux 63SN/37PB spherical solder balls which had a diameter of 0.76 mm 0.025 mm (.030 inch ± .001 inch) and a weight of approximately .00195 g. The plug and receptacle were then treated with FLUORAD, a solder anti-wicking material available from 3M Corporation. After such treatment the plug and receptacle were then dried in a convection oven for 2 hours at 105°C. The plug and receptacle were then positioned on separate circuit boards made of conventional reinforced epoxy printed circuit board material, having thickness of 1.55 mm (.061 inches). Referring to Fig. 9, a thermocouple was placed on the exterior surface of the plug in position T. Another thermocouple was centrally positioned upon the supporting board surface adjacent the plug. Both the plug and the receptacle were then treated in a panel-infrared (IR) conveyer solder reflow oven. As is conventional for this type of oven, the plug and receptacle were moved through six zones in the reflow oven. The conveyor speed was 330 mm/min (13 in/min). Heating temperatures in each zone are shown in Table 1. Minimum and maximum temperatures for the plug and for the supporting board are shown in Table 2. Both positive and negative maximum slopes are shown in Table 3. Rise time and fall time measured on the board between 180°C and 200°C are shown in Table 4. Temperature by time and distance for the plug is shown in the curve in Fig. 24b wherein the heavy line is the temperature at the thermocouple on the supporting board and the light line is temperature at the thermocouple on the plug exterior surface. A visual inspection of the plug and the receptacle after solder reflow showed that nearly all the solder balls had fused to the contact leads in their respective cavities. Solder ball height above the exterior surfaces of the plug and the receptacle also appeared to be relatively uniform. There was no noticeable warping or bending of the housing.

### Example 2

Another plug and receptacle were prepared in essentially the same way as was described in Example 1 and solder balls were emplaced in the recesses on the exterior sides. Several hours after the treatment in the solder reflow oven in Example 1, when atmospheric conditions were somewhat different, another plug and receptacle essentially similar to the ones used in Example 1 were subjected to similar reflow heating as were used in Example 1. Oven conditions are shown in Table 1. Minimum and maximum temperatures of the plug and the adjacent supporting board are shown in Table 2. Both positive and negative maximum slope is shown in Table 3, rise time and fall time measured on the board between 180°C and 200°C is shown in Table 4. Temperature by time and distance is shown in Fig. 24b. It will be seen that the curve shown in Fig. 24b is somewhat different than that shown in Fig. 24a which difference is attributed to different ambient atmospheric conditions. A visual inspection of the resulting connector showed similar results to those achieved in Example 1.

**TABLE 1**

| **Temperature (°C)** | | | | | | | |
|---|---|---|---|---|---|---|---|
| **Example** | **ZONE** | **#1** | **#2** | **#3** | **#4** | **#5** | **#6** |
| 1 | UPPER | 350 | Unheated | 275 | 230 | 310 | Unheated |
| 1 | LOWER | Unheated | Unheated | 275 | 230 | 310 | Unheated |
| 2 | UPPER | 350 | Unheated | 275 | 230 | 310 | Unheated |
| 2 | Lower | Unheated | Unheated | 275 | 230 | 710 | Unheated |

**TABLE 2**

| **Connector Board** | | | | |
|---|---|---|---|---|
| **Example** | **Max Temp (°C)** | **Time (Min. & Sec.)** | **Max Temp (°C)** | **Time (Min & Sec)** |
| 1 | 188 | 4:37.6 | ------- | ------- |
| 1 | --- | ------- | 232 | 4:19.8 |
| 2 | 191 | 4:53.2 | ------- | ------- |

**TABLE 3**

| **Positive and Negative Maximum Slope °C (Sec)** | | | | |
|---|---|---|---|---|
| | **Connector** | | **Board** | |
| **Example** | **Max** | **Time Reached (Min & Sec)** | **Max** | **Time Reached (Min & Sec)** |
| 1 | +2 | 0:50.4 | +2 | 0:30.4 |
| 1 | -2 | 6:45.2 | -3 | 5:58.8 |
| 2 | +3 | 7:08.0 | +3 | 1:14.8 |
| 2 | -15 | 6:13.8 | -7 | 6:14.0 |

**TABLE 4**

| **Rise Time and Full Time Between 180°C and 200°C** | | |
|---|---|---|
| **(Measured on Board)** | | |
| **Example** | **Rise Time (Min & Sec)** | **Fall Time (Min & Sec)** |
| 1 | 0:28.8 | 0:15.2 |
| 2 | 1:31.6 | 0:40.6 |

### Example 3

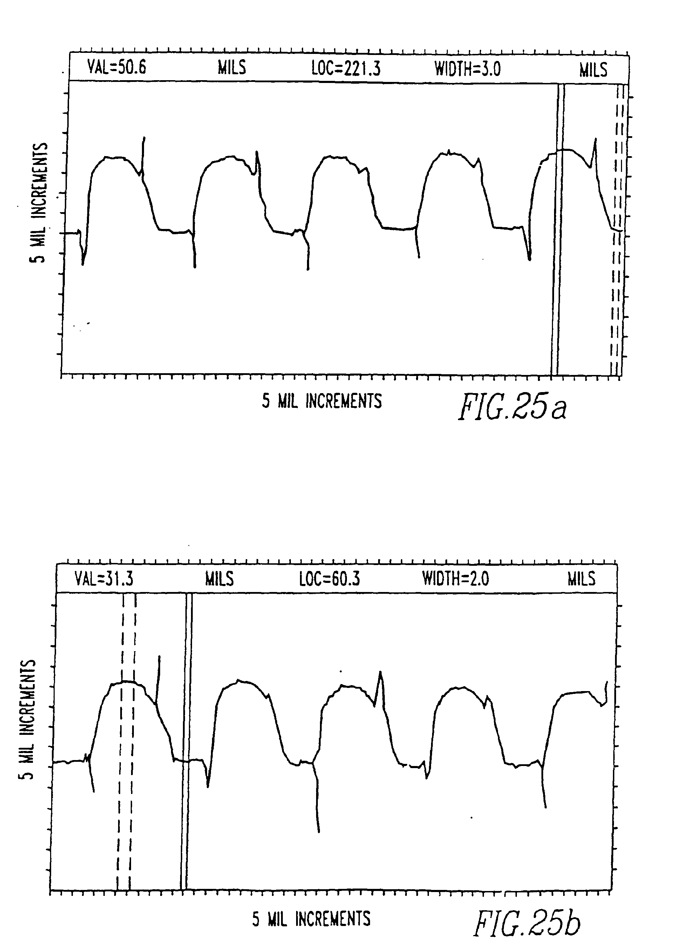

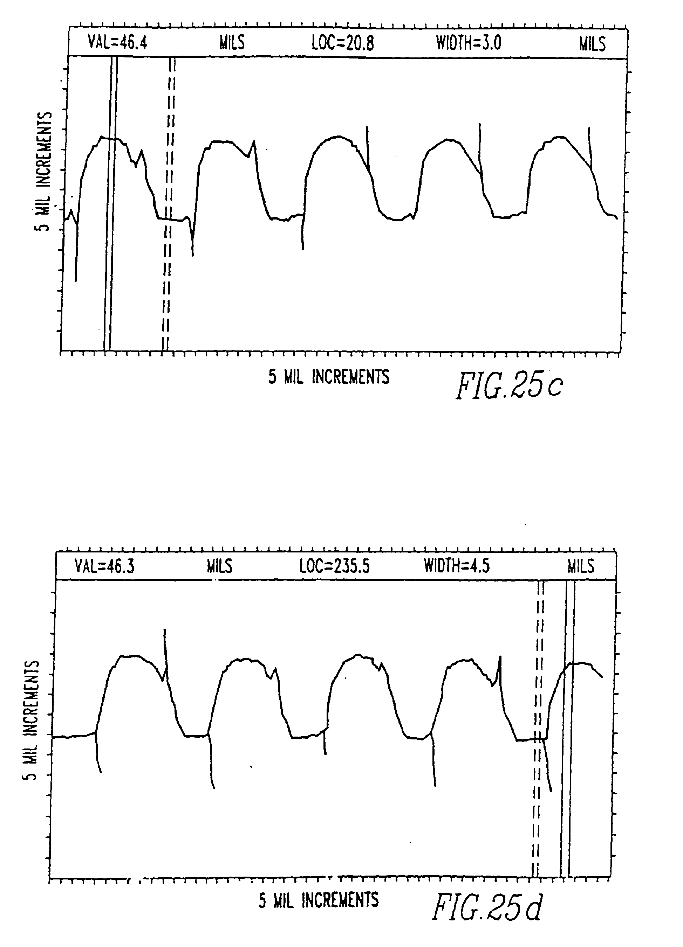

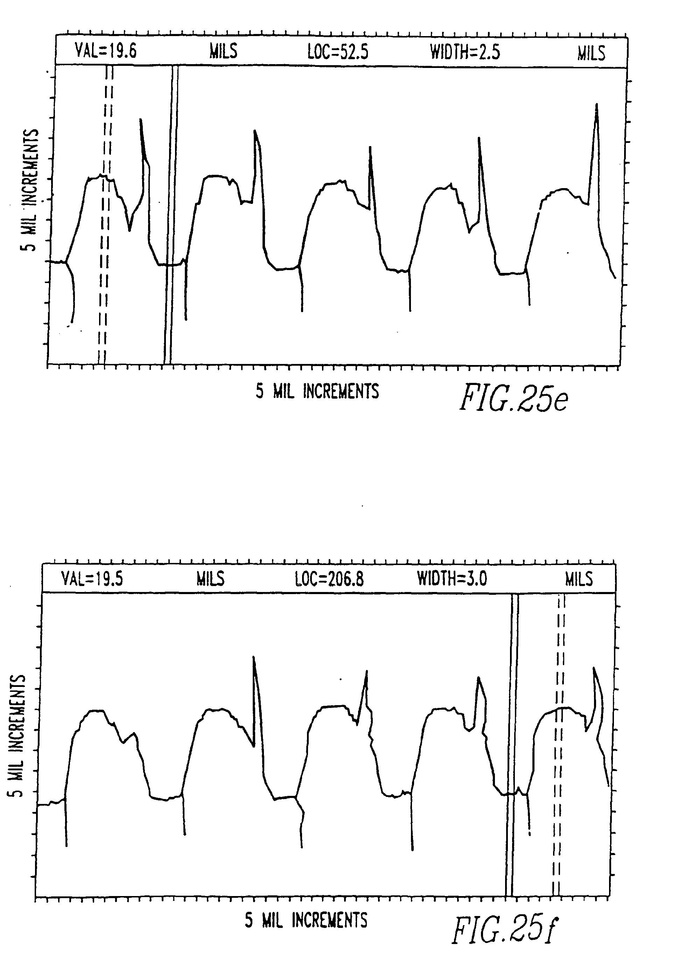

Another connector was made using essentially the same conditions as were described in Examples 1 and 2 except that the specific curves shown in Fig. 24a and 24b may have been somewhat different because of atmospheric conditions. After the completion of this connector, the solder balls at six locations on the exterior surface of the plug were examined by Laser Point Range Sensor (PRS) available from Cyber Optics Corporation of Minneapolis, Minnesota. Referring to Fig. 9, these locations are identified as areas 25a and 25b when the laser was directed from L₁, as areas 25c and 25d when the laser was directed from L₂ and as areas 25e and 25f when the laser was directed from L₃. At all these areas a laser profile was taken of the profiles of the five solder balls in each of these areas. Reproductions of these laser profile are shown in Fig. 25a - 25f. The height of each of these solder balls at its highest point above the plane of the exterior side of the plug is shown in Table 3. For each of these groups the solder ball closest to the front of the plug as shown in Fig. 9 was considered the first position in Table 5 and was the solder ball on the left of the graphs in Figs. 25a - 25f. An examination of these results reveals that in each group of five solder balls there was what was considered to be an acceptable degree of uniformity for the height of the solder balls.

**TABLE 5**

| **POSITION HEIGHT mm (.001 in)** | | | | | |
|---|---|---|---|---|---|
| **GROUP** | **1** | **2** | **3** | **4** | **5** |
| 25a | 0.45 (18.1) | 0.48 (18.9) | 0.49 (19.5) | 0.50 (19.6) | 0.48 (19.1) |
| 25b | 0.49 (19.2) | 0.47 (18.5) | 0.45 (17.6) | 0.47 (18.5) | 0.46 (18.0) |
| 25c | 0.52 (20.4) | 0.54 (21.1) | 0.55 (21.6) | 0.54 (21.1) | 0.54 (21.4) |
| 25d | 0.51 (19.9) | 0.51 (20.1) | 0.51 (20.1) | 0.54 (21.2) | 0.52 (20.5) |
| 25e | 0.46 (18.2) | 0.48 (18.9) | 0.49 (19.3) | 0.46 (18.2) | 0.47 (18.7) |
| 25f | 0.49 (19.1) | 0.46 (18.2) | 0.48 (19.0) | 0.46 (18.2) | 0.48 (18.9) |

### Example 4

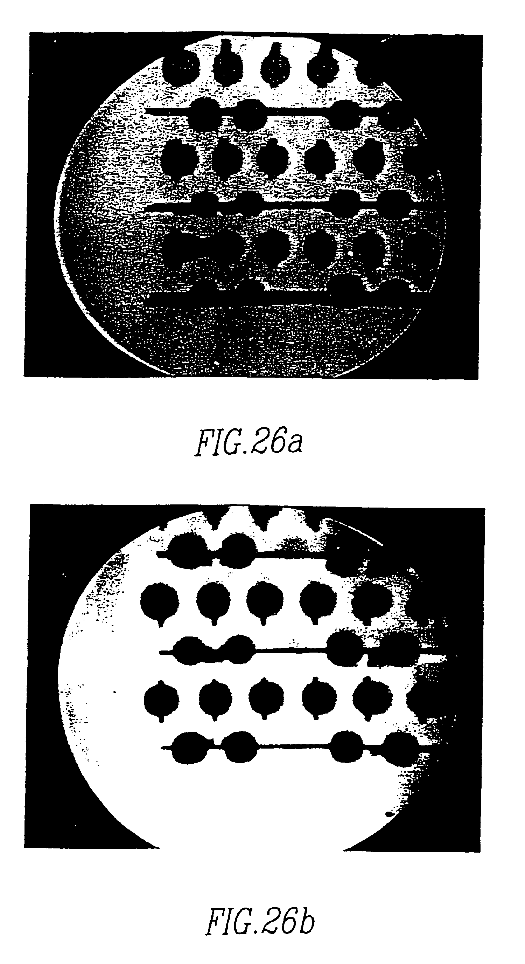

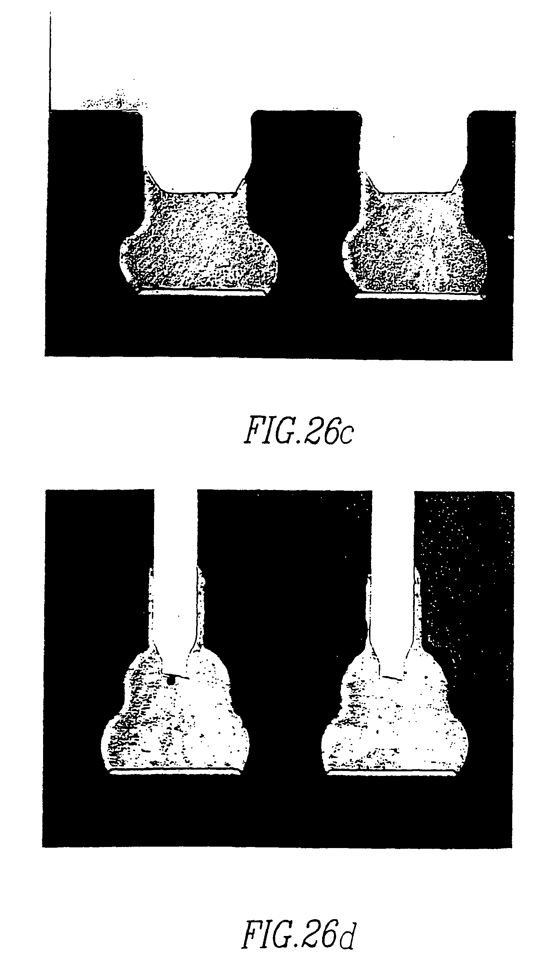

Another connector was made essentially according to the conditions described in Examples 1 and 2 except because of atmospheric conditions the specific curves shown on Figs. 24a and 24b may have been somewhat different. In almost all cases solder balls were satisfactorily fused to the contact leads and solder balls were of an acceptably uniform height above the plane of the exterior surfaces of the plug and receptacle on visual inspection. A stencil with a pattern matching the solder balls on both the plug and receptacle was used to apply solder paste onto conductive solder pads on two different circuit boards having a thickness of 1.55 mm (0.061 inches). The plug was positioned on one circuit board and the receptacle was positioned on the other. The plug and receptacle were then separately again treated in the conveyor oven under conditions similar to those described in fusing the solder balls to the contacts except that conveyor speed was decreased to 279.4 mm/sec (11 in/sec). After cooling, the plug and receptacle were found to have been satisfactorily fused to their respective boards. A photograph showing these x-rays of selected solder balls are attached respectively at Figs. 26a and 26b. Cross sectional electron microscope photographs were taken to show the fusing of the solder balls to the signal contact leads and the fusing of the solder balls to the printed circuit board material. These electron microscope photographs are shown respectively at Figs. 26c and 26d. There was only one short between adjacent signal contacts and good connections were made between the contacts and the solder balls and between the solder balls and the boards at all other points.

It will be appreciated that electrical connector and the method of its manufacture has been described in which the connector that can utilize BGA technologies for mounting on a PWB. Surprisingly and unexpectedly, it was also found that there was a relatively high degree of uniformity in the profiles of the solder balls and, in particular, in the weights and/or volume of the solder balls.

While the present invention has been described in connection with the preferred embodiments of the various figures, it is to be understood that other similar embodiments may be used or modifications and additions may be made to the described embodiment for performing the same function of the present invention without deviating therefrom. Further, the arrangements described can be used with respect to components other than connectors, that comprise housings formed of insulative materials which carry elements to be fused onto a PWB or other electrical substrate.

Therefore, the present invention should not be limited to any single embodiment, but rather construed in scope in accordance with the recitation of the appended claims.

## Claims

1. A method for placing a fusible electrically conductive material (100) on the exterior side of an electrical high density connector, having positioned contacts (66, 84) and having a base section (12) formed by an insulating material forming an exterior side (16) and an interior side (18) comprising the steps of:
- providing at least one recess (20, 22, 24, 26, 28) on the exterior side (16) of the base (12);
- extending the contact (66, 84) from adjacent the interior side (18) of the base (12) to the recess (20, 22, 24 26, 28) on the exterior side (16) of the base (12);
- positioning said fusible electrically conductive material (100) with at least a portion thereof in the recess (20, 22, 24, 26, 28) provided on the exterior side (16) of the base (12); and
- securing the fusible electrically conductive material (100) onto the contact while the fusible electrically conductive material (100) is positioned at the recess (20, 22, 24, 26, 28).

2. A method according to claim 1, **characterized in that** the fusible electrically conductive material is a solder ball (100).

3. A method according to claims 1 and 2, **characterized in that** the outer section (98) of the contact (84) and the solder ball (100) are partially contained in the recess (20, 22, 24, 26, 28).

4. A method according to claim 1, **characterized in that** in order to minimize stress built up in the insulative base (12) of the connector from insertion of contacts (66, 84) into the base (12) the method comprises the steps of:
- providing a housing with a plurality of contact receiving opening therein;
- inserting contacts (66, 84) into said openings;
- engaging a deformable member within the opening while the contact (66, 84) as the contact is inserted; and
- localizing any stress on the housing induced by insertions of the contact (66, 84) substantially to regions of the openings adjacent the deformable member (94).

5. An electrical high density connector having a base (12) with an exterior side (16) and an interior side (18) and made according to claims 1 to 4 **characterized by**
- at least one recess (20, 22, 24 26, 28) on the exterior side (16) of the base (12);
- a contact (66, 84) extending from adjacent the interior side of the base (12) to the recess (20, 22, 24, 26, 28) on the exterior side (16) of the base (12);
- fusible electrically conductive material being positioned with at least a portion thereof in the recess (20, 22, 24, 26, 28) provided on the exterior side (16) of the base (12); and
- said fusible electrically conductive material being secured onto the contact at the recess.

## Patentansprüche

1. Verfahren zur Anbringung eines schmelzbaren elektrisch leitenden Materials (100) auf der Außenseite eines elektrischen Verbinders mit hoher Kontaktdichte, der positionierte Kontakte (66, 84) und einen Basisbereich (12) aufweist, der aus isolierendem Material gefertigt ist und eine Außenseite (16) und eine Innenseite (18) aufweist, mit folgenden Verfahrensschritten:
- Vorsehen mindestens eines Schlitzes (20, 22, 24, 26, 28) auf der Außenseite (16) der Basis (12);
- Erstrecken des Kontakts (66, 84) aus einem der inneren Seiten (18) der Basis (12) nahe liegenden Bereich zum Schlitz (20, 22, 24, 26, 28) auf der Außenseite (16) der Basis (12);
- Positionierung des schmelzbaren elektrisch leitenden Materials (100) wenigstens teilweise in dem Schlitz (20, 22, 24, 26, 28), der auf der äußeren Seite (16) der Basis (12) angeordnet ist; und
- Befestigen des schmelzbaren elektrisch leitenden Materials (100) auf dem Kontakt, während das schmelzbare elektrisch leitende Material (100) am Schlitz (20, 22, 24, 26, 28) positioniert wird.

2. Verfahren nach Anspruch 1, **dadurch gekennzeichnet, dass** das schmelzbare elektrisch leitende Material eine Lötsinnkugel ?? (100) ist.

3. Verfahren nach Anspruch 1 oder 2, **dadurch gekennzeichnet, dass** der äußere Bereich (98) des Kontakts (84) und die Lötsinnkugel (100) teilweise in dem Schlitz in (20, 22, 24, 26, 28) enthalten sind.

4. Verfahren nach Anspruch 1, **dadurch gekennzeichnet, dass** um sich in der isolierenden Basis (12) aufbauende Spannungen zu minimieren, die durch das Einführen der Kontakte (66, 68) in die Basis (12) hervorgerufen werden, das Verfahren folgende Schritte aufweist:
- Vorsehen eines Gehäuses mit einer Mehrzahl von Kontaktaufnahmeöffnungen;
- Einführen der Kontakte (66, 84) in die Öffnungen;
- Einfügen eines verformbaren Gliedes in die Öffnung, während der Kontakt (66, 84) eingeführt ist; und
- Lokalisieren von Spannungen im Gehäuse, die durch das Einführen des Kontakts (66, 84) hervorgerufen sind in Bereichen der Öffnung, die benachbart zu den verformbaren Gliedern (94) liegen.

5. Elektrischer Verbinder mit hoher Kontaktdichte mit einer Basis (12), die eine Außenseite (16) und eine Innenseite (18) aufweist und nach dem Verfahren gemäß der Ansprüche 1 bis 4 hergestellt ist, **gekennzeichnet durch**:
- mindestens einen Schlitz (20, 22, 24, 26, 28) auf der Außenseite (16) der Basis (12);
- einen Kontakt (66, 84), der sich aus der Nähe der inneren Seite der Basis (12) zu dem Schlitz (20, 22, 24, 26, 28) auf der äußeren Seite (16) der Basis (12) erstreckt;
- schmelzbares, elektrisch leitendes Material, welches mindestens zum Teil in dem Schlitz (20, 22, 24, 26, 28) auf der Außenseite (16) der Basis (12) teilweise aufgenommen ist; und
- wobei das schmelzbare, elektrisch leitende Material auf dem Kontakt im Schlitz befestigt ist.

## Revendications

1. Procédé pour placer un matériau fusible conducteur électriquement (100) sur le côté extérieur d'un connecteur électrique à haute densité, ayant des contacts (66, 84) positionnés et ayant une section de base (12) formée par un matériau isolant formant un côté extérieur (16) et un côté intérieur (18), comprenant les étapes consistant à :
- fournir au moins un évidement (20, 22, 24, 26, 28) sur le côté extérieur (16) de la base (12) ;
- étendre le contact (66, 84) de la zone adjacente au côté intérieur (18) de la base (12) à l'évidement (20, 22, 24, 26, 28) sur le côté extérieur (16) de la base (12) ;
- positionner ledit matériau fusible conducteur électriquement (100) avec au moins une partie de celui-ci dans l'évidement (20, 22, 24, 26, 28) prévu sur le côté extérieur (16) de la base (12) ; et
- fixer le matériau fusible conducteur électriquement (100) sur le contact tandis que le matériau fusible conducteur électriquement (100) est positionné au niveau de l'évidement (20, 22, 24, 26, 28).

2. Procédé selon la revendication 1, **caractérisé en ce que** le matériau fusible conducteur électriquement est une bille de soudure (100).

3. Procédé selon les revendications 1 et 2, **caractérisé en ce que** la section externe (98) du contact (84) et la bille de soudure (100) sont partiellement contenues dans l'évidement (20, 22, 24, 26, 28).

4. Procédé selon la revendication 1, **caractérisé en ce que**, afin de minimiser la contrainte accumulée dans la base isolante (12) du connecteur liée à l'insertion de contacts (66, 84) dans la base (12), le procédé comprend les étapes consistant à :
- prévoir un logement avec une pluralité d'ouvertures de réception de contacts ;
- insérer les contacts (66, 84) dans lesdites ouvertures ;
- mettre en prise un élément déformable à l'intérieur de l'ouverture tandis que le contact (66, 84) est inséré ; et
- localiser toute contrainte sur le logement induite par les insertions du contact (66, 84) sensiblement sur les zones des ouvertures adjacentes à l'élément déformable (94).

5. Connecteur électrique à haute densité ayant une base (12) avec un côté extérieur (16) et un côté intérieur (18) et constitué selon les revendications 1 à 4, **caractérisé par** :
- au moins un évidement (20, 22, ²24, 26, 28) sur le côté extérieur (16) de la base (12) ;
- un contact (66, 84) s'étendant à partir de la zone adjacente au côté intérieur de la base (12) vers l'évidement (20, 22, 24, 26, 28) sur le côté extérieur (16) de la base (12) ;
- un matériau fusible conducteur électriquement étant positionné avec au moins une partie de celui-ci dans l'évidement (20, 22, 24, 26, 28) prévu sur le côté extérieur (16) de la base (12) ; et
- ledit matériau fusible conducteur électriquement étant fixé sur le contact au niveau de l'évidement.
